# EUROPEAN PATENT APPLICATION

(11) **EP 4 848 285 A1**
(43) Date of publication of application: **02.12.2026**
(21) Application number: 25221049.7
(22) Date of filing: 05.12.2025
(51) Int. Cl.: G11C 7/10, G11C 11/4093

(54) **RECEIVING CIRCUIT AND SEMICONDUCTOR MEMORY APPARATUS INCLUDING THE RECEIVING CIRCUIT**

(30) Priority: 30.05.2025 KR 20250071210
(71) Applicant: SK hynix Inc., Bubal-eub Icheon-si Gyeonggi-do 17336 (KR)
(72) Inventor: JANG, Jun Seo, 17336 Icheon-si, Gyeonggi-do (KR); JEON, Jun Tak, 17336 Icheon-si, Gyeonggi-do (KR); HWANG, Jun Sun, 17336 Icheon-si, Gyeonggi-do (KR); SEO, Beom Kyu, 17336 Icheon-si, Gyeonggi-do (KR); HONG, Jae Hyeong, 17336 Icheon-si, Gyeonggi-do (KR)
(74) Representative: Isarpatent

(57) **Abstract**

The present disclosure provides a receiving circuit and a semiconductor memory apparatus. The receiving circuit includes a first receiving block, a second receiving block, a first rectifying circuit, and a second rectifying circuit. The first receiving block receives a second power supply voltage and performs first signal processing on an input signal using the second power supply voltage to generate a preliminary output signal. The second receiving block receives a first power supply voltage and performs second signal processing on the preliminary output signal using the first power supply voltage to generate an output signal. The first rectifying circuit generates the first power supply voltage. The second rectifying circuit generates the second power supply voltage having a voltage level higher than the voltage level of the first power supply voltage.

## Description

### BACKGROUND

### 1.TECHNICAL FIELD

Various embodiments generally relate to a semiconductor circuit, and more particularly, to a receiving circuit and a semiconductor memory apparatus including the receiving circuit.

### 2. RELATED ART

A semiconductor apparatus includes a receiving circuit for receiving a signal, such as data, transmitted by an external. As the input and output speed of the semiconductor apparatus increases, data reliability decreases.

During continuous data input, the operation sensitivity of the receiving circuit decreases due to associated issues, which causes a problem of reduced operational reliability of the semiconductor apparatus. Accordingly, there is a need to develop a technology capable of improving the operation sensitivity of the receiving circuit.

### SUMMARY

In an embodiment, a receiving circuit may include a first receiving block, a second receiving block, a first rectifying circuit, and a second rectifying circuit. The first receiving block may be configured to receive a second power supply voltage and may be configured to perform first signal processing on an input signal using the second power supply voltage to generate a preliminary output signal. The second receiving block may be configured to receive a first power supply voltage and may be configured to perform second signal processing on the preliminary output signal using the first power supply voltage to generate an output signal. The first rectifying circuit may be configured to generate the first power supply voltage. The second rectifying circuit may be configured to generate the second power supply voltage having a voltage level higher than a voltage level of the first power supply voltage.

In an embodiment, a receiving circuit may include a first receiving block, a second receiving block, a first rectifying circuit, a second rectifying circuit, and a multiplexing circuit. The first receiving block may be configured to receive a third power supply voltage and may be configured to generate a preliminary output signal by performing a first signal processing operation on an input signal using the third power supply voltage. The second receiving block may be configured to receive a first power supply voltage and may be configured to generate an output signal by performing a second signal processing operation on the preliminary output signal using the first power supply voltage. The first rectifying circuit may be configured to generate the first power supply voltage. The second rectifying circuit may be configured to generate a second power supply voltage having a voltage level higher than a voltage level of the first power supply voltage. The multiplexing circuit may be configured to output the second power supply voltage as the third power supply voltage when a voltage selection signal is at a first logic level, and may be configured to output the first power supply voltage as the third power supply voltage when the voltage selection signal is at a second logic level.

In an embodiment, a semiconductor memory apparatus may include a memory cell array, an input/output pad array, and a data input/output circuit. The input/output pad array may be configured to receive a command, an address, and a clock signal, and may include a plurality of pads for inputting and outputting data. The data input/output circuit may be coupled between the memory cell array and the input/output pad array and may include a receiving circuit. The receiving circuit may be configured to supply a first power supply voltage before a data input interval, may be configured to supply a second power supply voltage having a voltage level higher than a voltage level of the first power supply voltage during the data input interval, and may be configured to supply the first power supply voltage after the data input interval ends.

### BRIEF DESCRIPTION OF THE DRAWINGS

FIG. 1 is a diagram illustrating a configuration of a receiving circuit, according to an embodiment of the present disclosure.
FIG. 2 is a diagram illustrating a configuration of a first rectifying circuit of FIG. 1.
FIG. 3 is a diagram illustrating a configuration of a second rectifying circuit of FIG. 1.
FIG. 4 is a diagram illustrating an operation of a receiving circuit, according to an embodiment of the present disclosure.
FIG. 5 is a diagram illustrating a configuration of a receiving circuit according to an embodiment of the present disclosure.
FIG. 6 is a diagram illustrating a configuration of a reception control circuit, according to an embodiment of the present disclosure.
FIG. 7A is a diagram illustrating a configuration of a reception control circuit, according to an embodiment of the present disclosure.
FIGS. 7B to 7D are diagrams illustrating operating conditions of the reception control circuit of FIG. 7A.
FIG. 8A is a diagram illustrating a configuration of a reception control circuit, according to an embodiment of the present disclosure.
FIG. 8B is a diagram illustrating an operating condition of the reception control circuit of FIG. 8A.
FIG. 9 is a diagram illustrating an operation of a receiving circuit, according to an embodiment of the present disclosure.
FIG. 10 is a diagram illustrating a configuration of a semiconductor memory apparatus, according to an embodiment of the present disclosure.

### DETAILED DESCRIPTION

Various embodiments can improve signal reception performance by increasing the operation sensitivity of a receiving circuit.

Hereinafter, some embodiments of the present disclosure will be described in more detail with reference to the accompanying drawings.

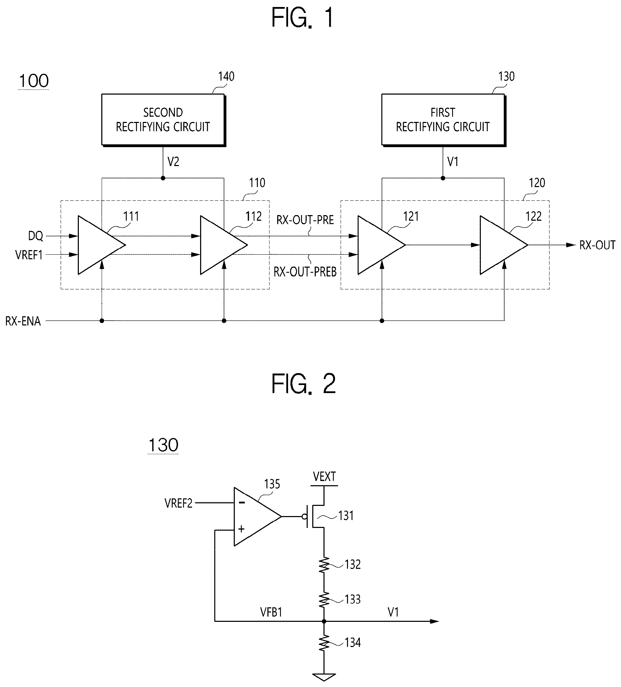

FIG. 1 is a diagram illustrating a configuration of a receiving circuit 100, according to an embodiment of the present disclosure.

Referring to FIG. 1, the receiving circuit 100 may include a first receiving block 110, a second receiving block 120, a first rectifying circuit 130, and a second rectifying circuit 140.

The first receiving block 110 may receive data DQ, a first reference voltage VREF1, a receiving enable signal RX-ENA, and a second power supply voltage V2, and may output a preliminary output signal RX-OUT-PRE/RX-OUT-PREB. The preliminary output signal RX-OUT-PRE/RX-OUT-PREB is a differential signal. The first receiving block 110 may perform first signal processing, that is, amplify the data DQ using the second power supply voltage V2 to generate the preliminary output signal RX-OUT-PRE/RX-OUT-PREB. The first receiving block 110 may include at least one amplification circuit. FIG. 1 is merely an example in which the first receiving block 110 includes a first amplification circuit 111 and a second amplification circuit 112, and the number of amplification circuits may vary depending on the design scheme. The first amplification circuit 111 may amplify a level difference between the data DQ and the first reference voltage VREF1 to generate a differential output signal. The second amplification circuit 112 may amplify a level difference of the differential output signal output from the first amplification circuit 111 to generate the preliminary output signal RX-OUT-PRE/RX-OUT-PREB. The first amplification circuit 111 and the second amplification circuit 112 may be circuit-designed in a current mode logic (CML) scheme.

The second receiving block 120 may receive the preliminary output signal RX-OUT-PRE/RX-OUT-PREB, the receiving enable signal RX-ENA, and a first power supply voltage V1, and may output an output signal RX-OUT. The second receiving block 120 may perform second signal processing, that is, perform a differential-to-single-ended conversion on the preliminary output signal RX-OUT-PRE/RX-OUT-PREB using the first power supply voltage V1 to generate the output signal RX-OUT. The second receiving block 120 may include at least one circuit block circuit-designed in a rail-to-rail scheme. The second receiving block 120 may include a differential/single signal conversion circuit 121 and a slicer 122. FIG. 1 is merely an example in which the second receiving block 120 includes the differential/single signal conversion circuit 121 and the slicer 122, and the circuit configuration may change depending on a design scheme. The differential/single signal conversion circuit 121 may be a differential-to-single-ended circuit that converts the differential preliminary output signal RX-OUT-PRE/RX-OUT-PREB into a single-ended signal and output it. The slicer 122 may operate as a filter and generate the output signal RX-OUT by limiting a level of an output of the differential/single signal conversion circuit 121. The differential/single signal conversion circuit 121 may be circuit-designed in a rail-to-rail scheme.

The first rectifying circuit 130 may generate the first power supply voltage V1. The first rectifying circuit 130 may be configured as a low dropout regulator.

The second rectifying circuit 140 may generate the second power supply voltage V2, which has a level higher than that of the first power supply voltage V1. The second rectifying circuit 140 may be configured as a low dropout regulator. Because the first receiving block 110 is designed in the current mode logic scheme and consumes DC current, a stable power supply may be provided by the second rectifying circuit 140 configured as a low dropout regulator.

FIG. 2 is a diagram illustrating a configuration of the first rectifying circuit 130 of FIG. 1.

Referring to FIG. 2, the first rectifying circuit 130 may include a transistor 131, dividing resistors 132 to 134, and a comparator 135.

The transistor 131 may drive an output node with a level of an external power supply voltage VEXT according to a gate level to generate the first power supply voltage V1. The dividing resistors 132, 133, and 134 may divide the first power supply voltage V1 by a predetermined division ratio to generate a feedback voltage VFB1. The word "predetermined" as used herein with respect to a parameter, such as a predetermined timing, time, or voltage level, means that a value for the parameter is determined prior to the parameter being used in a process or algorithm. For some embodiments, the value for the parameter is determined before the process or algorithm begins. In other embodiments, the value for the parameter is determined during the process or algorithm but before the parameter is used in the process or algorithm. The comparator 135 may adjust the gate level of the transistor 131 according to a result of comparing the feedback voltage VFB1 and a second reference voltage VREF2.

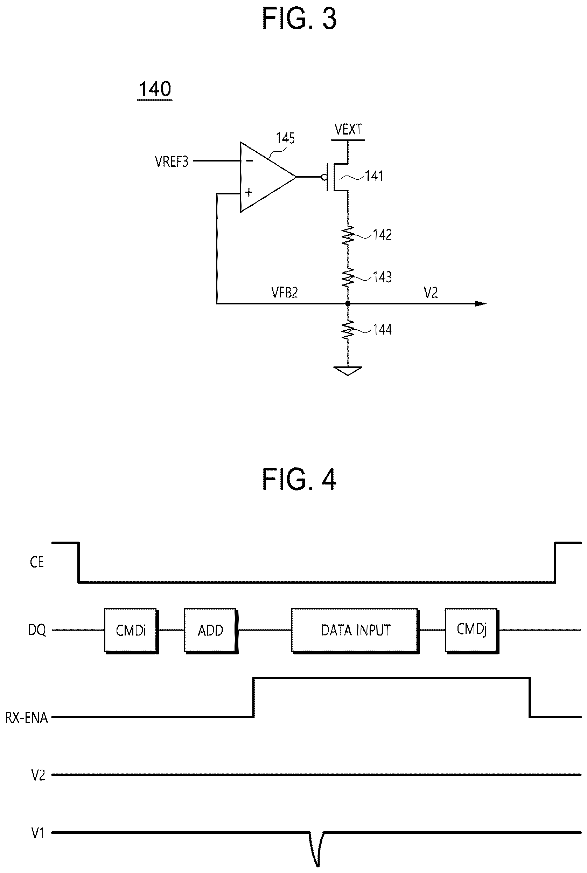

FIG. 3 is a diagram illustrating a configuration of the second rectifying circuit 140 of FIG. 1.

Referring to FIG. 3, the second rectifying circuit 140 may include a transistor 141, dividing resistors 142 to 144, and a comparator 145.

The transistor 141 may drive an output node with a level of the external power supply voltage VEXT according to a gate level to generate the second power supply voltage V2. The dividing resistors 142, 143, and 144 may divide the second power supply voltage V2 by a predetermined division ratio to generate a feedback voltage VFB2. The comparator 145 may adjust the gate level of the transistor 141 according to a result of comparing the feedback voltage VFB2 and a third reference voltage VREF3. The second rectifying circuit 140 may be configured to generate the second power supply voltage V2 to have a level higher than that of the first power supply voltage V1 by setting a level of the third reference voltage VREF3 to be higher than that of the second reference voltage VREF2 in FIG. 2.

FIG. 4 is a diagram illustrating an operation of the receiving circuit 100, according to an embodiment of the present disclosure.

In a state in which a chip enable signal CE is activated to a logic low level, a first command CMDi and an address ADD may be input, and a data input operation may be performed after a predetermined time interval. The first command CMDi may include a command related to data input, such as a write command and a program command.

After the first command CMDi is input and a predetermined time interval elapses, the receiving enable signal RX-ENA may be activated to a logic high level.

As the receiving enable signal RX-ENA is activated to a logic high level, the first receiving block 110 and the second receiving block 120 may be activated and may receive data DQ to generate the output signal RX-OUT.

As the differential/single signal conversion circuit 121 of the second receiving block 120 operates in a rail-to-rail scheme, an undershoot may occur due to increased current consumption. In contrast, because the first receiving block 110 is designed in a current mode logic scheme and consumes DC current, and is driven by the second power supply voltage V2, which has a higher level than that of the first power supply voltage V1 supplied to the second receiving block 120, a stable power supply may be provided, and thus an undershoot may be mitigated or may not occur at all. Accordingly, reception performance of the receiving circuit 100 may be improved.

The receiving enable signal RX-ENA may remain at a logic high level during the data input operation and may be deactivated to a logic low level as a second command CMDj is input. As the receiving enable signal RX-ENA is deactivated to a logic low level, the first receiving block 110 and the second receiving block 120 may be deactivated. The second command CMDj may include a command indicating an end of the data input operation.

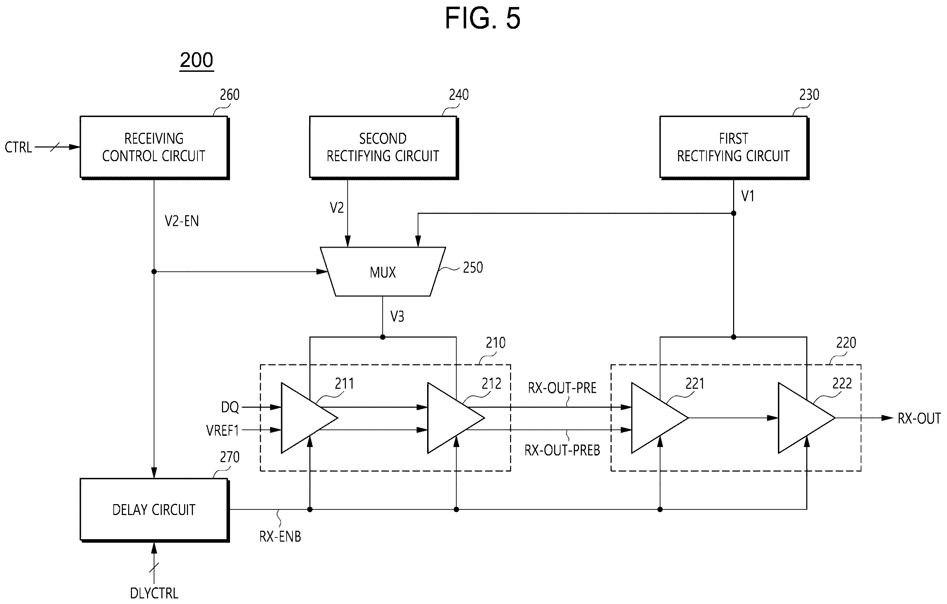

FIG. 5 is a diagram illustrating a configuration of a receiving circuit 200, according to an embodiment of the present disclosure.

Referring to FIG. 5, the receiving circuit 200 may include a first receiving block 210, a second receiving block 220, a first rectifying circuit 230, a second rectifying circuit 240, a multiplexing circuit MUX 250, a receiving control circuit 260, and a delay circuit 270.

The first receiving block 210 may receive data DQ, a first reference voltage VREF1, a receiving enable signal RX-ENB, and a third power supply voltage V3, and may output a preliminary output signal RX-OUT-PRE/RX-OUT-PREB. The first receiving block 210 may perform first signal processing, that is, amplify the data DQ using the third power supply voltage V3 to generate the preliminary output signal RX-OUT-PRE/RX-OUT-PREB. The first receiving block 210 may include at least one amplification circuit. FIG. 5 is merely an example in which the first receiving block 210 includes a first amplification circuit 211 and a second amplification circuit 212, and the number of amplification circuits may change depending on a design scheme. The first amplification circuit 211 may amplify a level difference between the data DQ and the first reference voltage VREF1 to generate a differential output signal. The second amplification circuit 212 may amplify a level difference of the differential output signal output from the first amplification circuit 211 to generate the preliminary output signal RX-OUT-PRE/RX-OUT-PREB. The first amplification circuit 211 and the second amplification circuit 212 may be circuit-designed in a current mode logic (CML) scheme.

The second receiving block 220 may receive the preliminary output signal RX-OUT-PRE/RX-OUT-PREB, the receiving enable signal RX-ENB, and a first power supply voltage V1, and may output an output signal RX-OUT. The second receiving block 220 may perform second signal processing, that is, perform a differential-to-single-ended conversion on the preliminary output signal RX-OUT-PRE/RX-OUT-PREB using the first power supply voltage V1 to generate the output signal RX-OUT. The second receiving block 220 may include at least one circuit block circuit-designed in a rail-to-rail scheme. The second receiving block 220 may include a differential/single signal conversion circuit 221 and a slicer 222. FIG. 5 is merely an example in which the second receiving block 220 includes the differential/single signal conversion circuit 221 and the slicer 222, and the circuit configuration may change depending on a design scheme. The differential/single signal conversion circuit 221 may convert the differential preliminary output signal RX-OUT-PRE/RX-OUT-PREB into a single-ended signal and output it. The slicer 222 may operate as a filter and generate the output signal RX-OUT by limiting a level of an output of the differential/single signal conversion circuit 221. The differential/single signal conversion circuit 221 may be circuit-designed in a rail-to-rail scheme.

The first rectifying circuit 230 may generate the first power supply voltage V1. The first rectifying circuit 230 may be configured as a low dropout regulator.

The second rectifying circuit 240 may generate the second power supply voltage V2, which has a level higher than that of the first power supply voltage V1. The second rectifying circuit 240 may be configured as a low dropout regulator.

The multiplexing circuit 250 may output the second power supply voltage V2 as the third power supply voltage V3 when a voltage selection signal V2-EN is at a first logic level (e.g., a logic high level), and may output the first power supply voltage V1 as the third power supply voltage V3 when the voltage selection signal V2-EN is at a second logic level (e.g., a logic low level).

The receiving control circuit 260 may receive a plurality of control signals CTRL and may output the voltage selection signal V2-EN. The receiving control circuit 260 may generate the voltage selection signal V2-EN at the first logic level during an interval in which a data input operation is performed, based on the plurality of control signals CTRL. The receiving control circuit 260 may also generate the voltage selection signal V2-EN at the first logic level during an interval in which a data input operation is performed and during an interval set to a low-speed standby mode.

The delay circuit 270 may receive the voltage selection signal V2-EN and a delay control signal DLYCTRL, and may output the receiving enable signal RX-ENB. The delay circuit 270 may generate the receiving enable signal RX-ENB by delaying the voltage selection signal V2-EN by a delay time interval adjusted by the delay control signal DLYCTRL. The delay control signal DLYCTRL may include at least one of a signal set in a mode register set and a test mode signal. A delay time interval of the delay circuit 270 may be varied by changing a setting of the mode register set or controlling the test mode signal.

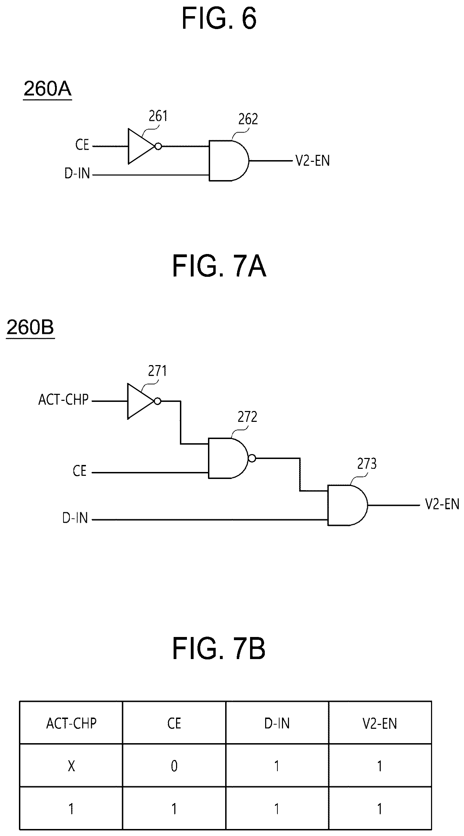

FIG. 6 is a diagram illustrating a configuration of a receiving control circuit 260A, according to an embodiment of the present disclosure.

Referring to FIG. 6, the receiving control circuit 260A may receive the plurality of control signals CTRL, including a chip enable signal CE and a data input flag D-IN. The chip enable signal CE may be used to determine whether to activate a semiconductor apparatus including the receiving circuit 200. The semiconductor apparatus may be a semiconductor memory apparatus, and the semiconductor memory apparatus may include at least one semiconductor chip. For example, the semiconductor chip may be activated during a low-level interval of the chip enable signal CE. The data input flag D-IN may be used as a signal indicating that data is being input to the semiconductor chip. The data input flag D-IN may transition to a logic high level after a predetermined time interval from when the first command CMDi described with reference to FIG. 4 is input, and may transition to a logic low level after a predetermined time interval from when the second command CMDj is input.

The receiving control circuit 260A may include a first logic gate 261 and a second logic gate 262. The first logic gate 261 may invert the chip enable signal CE and output the result. The second logic gate 262 may output a result obtained by performing an AND operation on an output of the first logic gate 261 and the data input flag D-IN as the voltage selection signal V2-EN. The receiving control circuit 260A may generate the voltage selection signal V2-EN at a first logic level, that is, a logic high level, during an interval in which data is input to the semiconductor chip and an interval including a predetermined timing margin before and after the data input interval.

FIG. 7A is a diagram illustrating a configuration of a receiving control circuit 260B, according to an embodiment of the present disclosure, and FIGS. 7B to 7D are diagrams illustrating operating conditions of the receiving control circuit 260B shown in FIG. 7A.

Referring to FIG. 7A, the receiving control circuit 260B may receive a plurality of control signals CTRL, including an active signal ACT-CHP, the chip enable signal CE, and the data input flag D-IN. The active signal ACT-CHP may be internally generated in the semiconductor apparatus according to the chip enable signal CE.

The receiving control circuit 260B may include first to third logic gates 271 to 273. The first logic gate 271 may invert the active signal ACT-CHP and output the result. The second logic gate 272 may output a result obtained by performing a NAND operation on an output of the first logic gate 271 and the chip enable signal CE. The third logic gate 273 may output a result obtained by performing an AND operation on an output of the second logic gate 272 and the data input flag D-IN as the voltage selection signal V2-EN.

Referring to FIG. 7B, when the chip enable signal CE is at a logic low level and the data input flag D-IN is at a logic high level, the receiving control circuit 260B may generate the voltage selection signal V2-EN at a logic high level regardless or independent of the active signal ACT-CHP.

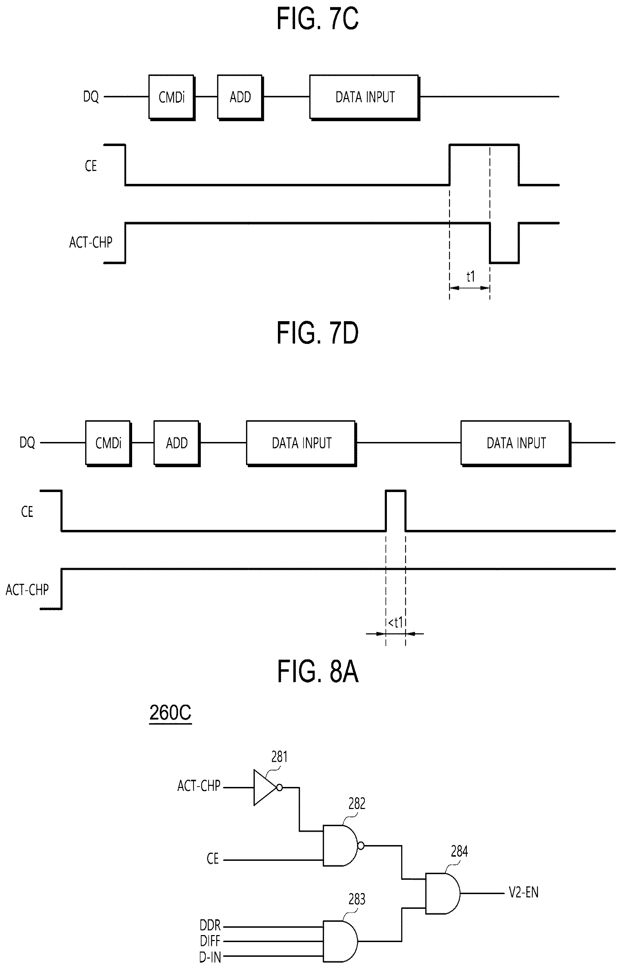

Referring to FIG. 7C, the active signal ACT-CHP may transition to a logic high level as the chip enable signal CE transitions to a logic low level. The chip enable signal CE may transition to a logic high level after a data input operation is completed.

If no further data input operation is required from outside the semiconductor apparatus, a logic high level interval of the chip enable signal CE is maintained for at least a predetermined time interval t1.

The active signal ACT-CHP transitions to a logic low level if the chip enable signal CE remains at a logic high level for at least the predetermined time interval t1.

Referring to FIG. 7D, the active signal ACT-CHP may transition to a logic high level as the chip enable signal CE transitions to a logic low level. The chip enable signal CE may transition to a logic high level after a data input operation is completed.

If an additional data input operation is required from outside the semiconductor apparatus, a logic high level interval of the chip enable signal CE is maintained for less than the predetermined time interval t1.

The active signal ACT-CHP remains at a logic high level if the logic high level interval of the chip enable signal CE is less than the predetermined time interval t1.

After the chip enable signal CE transitions to a logic low level, an additional data input operation may be performed.

As described above, the semiconductor apparatus may maintain the active signal ACT-CHP at a logic high level in preparation for additional data input when the chip enable signal CE remains at a logic high level for less than the predetermined time interval t1.

Accordingly, as shown in FIG. 7B, even when the chip enable signal CE is at a logic high level, the voltage selection signal V2-EN may be generated at a logic high level if the active signal ACT-CHP and the data input flag D-IN are at a logic high level.

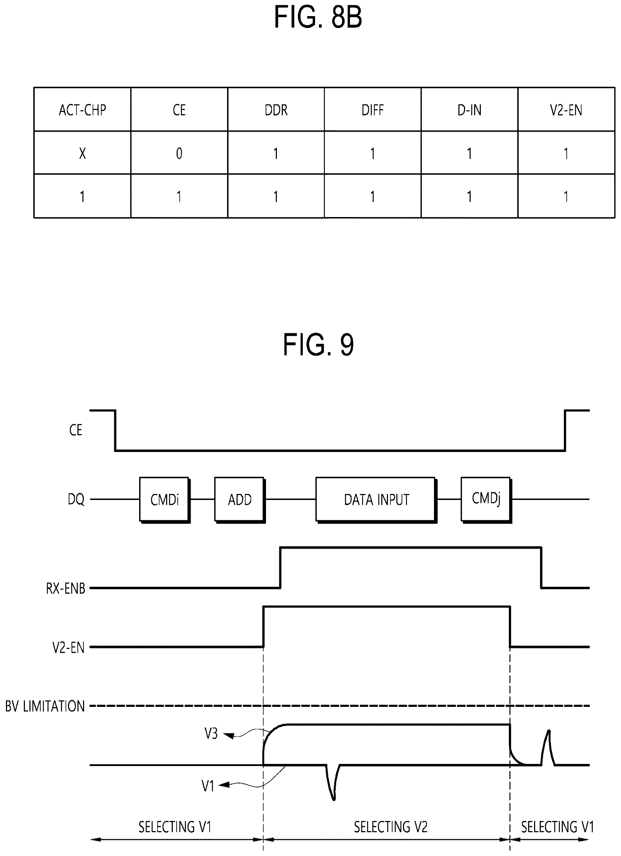

FIG. 8A is a diagram illustrating a configuration of a receiving control circuit 260C, according to an embodiment of the present disclosure. FIG. 8B is a diagram illustrating an operating condition of the receiving control circuit 260C shown in FIG. 8A.

Referring to FIG. 8A, the receiving control circuit 260C may receive a plurality of control signals CTRL, including the chip enable signal CE, the data input flag D-IN, the active signal ACT-CHP, a double data rate mode signal DDR, and a differential mode signal DIFF. The double data rate mode signal DDR may be set to a logic high level while a semiconductor chip operates in a double data rate mode, and may be set to a logic low level while it operates in a single data rate mode. The differential mode signal DIFF may be set to a logic high level while the semiconductor chip operates in a differential mode as a signal processing scheme, and may be set to a logic low level while it operates in a single-ended mode as the signal processing scheme.

The receiving control circuit 260C may include first to fourth logic gates 281 to 284. The first logic gate 281 may invert the active signal ACT-CHP and output the result. The second logic gate 282 may output a result obtained by performing a NAND operation on an output of the first logic gate 281 and the chip enable signal CE. The third logic gate 283 may output a result obtained by performing an AND operation on the double data rate mode signal DDR, the differential mode signal DIFF, and the data input flag D-IN. The fourth logic gate 284 may output a result obtained by performing an AND operation on outputs of the second logic gate 282 and the third logic gate 283 as the voltage selection signal V2-EN.

Referring to FIG. 8B, the receiving control circuit 260C may generate the voltage selection signal V2-EN at a logic high level if a first operation condition or a second operation condition is satisfied, so that the first receiving block 210 operates using the second power supply voltage V2, which has a level higher than that of the first power supply voltage V1, during an interval in which the first receiving block 210 operates in a data input mode, thereby enhancing sensitivity.

The first operation condition is that the double data rate mode signal DDR and the differential mode signal DIFF are at a logic high level, the chip enable signal CE is at a logic low level, and the data input flag DIN is at a logic high level. In this case, the voltage selection signal V2-EN is generated at a logic high level during an interval in which data input is performed and an interval including a predetermined timing margin before and after the data input interval.

The second operation condition is that the double data rate mode signal DDR and the differential mode signal DIFF are at a logic high level, the chip enable signal CE is at a logic high level, the active signal ACT-CHP is at a logic high level, and the data input flag D-IN is at a logic high level. In this case, the voltage selection signal V2-EN is also generated at a logic high level during an interval in which data input is performed and an interval including a predetermined timing margin before and after the data input interval.

If a semiconductor memory apparatus is designed for the single data rate mode and the single-ended mode, target reception performance may be achieved even when the first receiving block 210 uses the first power supply voltage V1 during an interval in which the first receiving block 210 operates in a data input mode. Meanwhile, if the semiconductor memory apparatus is designed for the double data rate mode and the differential mode, it is advantageous to use the second power supply voltage V2, which has a level higher than that of the first power supply voltage V1, during an interval in which the first receiving block 210 operates in the data input mode in order to achieve the target reception performance. Accordingly, the first operation condition and the second operation condition are both defined to include the double data rate mode and the differential mode in common, and if either the double data rate mode or the differential mode is not satisfied, the first power supply voltage V1 is used to ensure the target reception performance while reducing power consumption.

FIG. 9 is a diagram illustrating an operation of the receiving circuit 200, according to an embodiment of the present disclosure.

In a state in which the chip enable signal CE is activated to a logic low level, a first command CMDi and an address ADD may be input, and a data input operation may be performed after a predetermined time interval. The first command CMDi may include a command related to data input, such as a write command.

Until an interval related to the data input operation begins, the data input flag D-IN remains at a logic low level, so the voltage selection signal V2-EN is generated at a logic low level.

During an interval in which the voltage selection signal V2-EN is at a logic low level, the first power supply voltage V1 is provided to the first receiving block 210 as the third power supply voltage V3. The first power supply voltage V1 is provided to the second receiving block 220 regardless or independent of the voltage selection signal V2-EN.

The voltage selection signal V2-EN transitions to a logic high level according to the operation conditions described with reference to FIGS. 6 to 8B, including a condition in which the data input flag D-IN transitions to a logic high level.

During an interval in which the voltage selection signal V2-EN is at a logic high level, the second power supply voltage V2 is provided to the first receiving block 210 as the third power supply voltage V3.

After the voltage selection signal V2-EN transitions to a logic high level, the receiving enable signal RX-ENB is activated to a logic high level after a delay time interval adjusted by the delay circuit 270.

As the receiving enable signal RX-ENB is activated to a logic high level, the first receiving block 210 and the second receiving block 220 are activated and may receive data DQ to generate the output signal RX-OUT.

When the interval related to the data input operation has elapsed and the data input flag D-IN transitions to a logic low level, the voltage selection signal V2-EN transitions to a logic low level according to the aforementioned operation conditions.

As the voltage selection signal V2-EN transitions to a logic low level, the first power supply voltage V1 is provided to the first receiving block 210 as the third power supply voltage V3.

After the voltage selection signal V2-EN transitions to a logic low level, the receiving enable signal RX-ENB is deactivated to a logic low level after a delay time interval adjusted by the delay circuit 270.

As the receiving enable signal RX-ENB is deactivated to a logic low level, the first receiving block 210 and the second receiving block 220 may be deactivated.

At the time point when the receiving enable signal RX-ENB is deactivated to a logic low level, that is, when the first receiving block 210 is deactivated, an overshoot may occur in which a voltage level sharply increases due to a sudden drop in the load that uses the third power supply voltage V3. According to an embodiment of the present disclosure, by using the second power supply voltage V2 as the third power supply voltage V3 before the receiving enable signal RX-ENB is activated to a logic high level, the sensitivity may be increased, thereby enhancing the reception performance of the receiving circuit 200. Furthermore, by changing the level of the third power supply voltage V3 to the first power supply voltage V1, which is lower than the second power supply voltage V2, before the receiving enable signal RX-ENB is deactivated to a logic low level, the overshoot may be mitigated or prevented from exceeding a breakdown voltage BV. The breakdown voltage refers to a voltage level that may cause damage to elements constituting a semiconductor circuit.

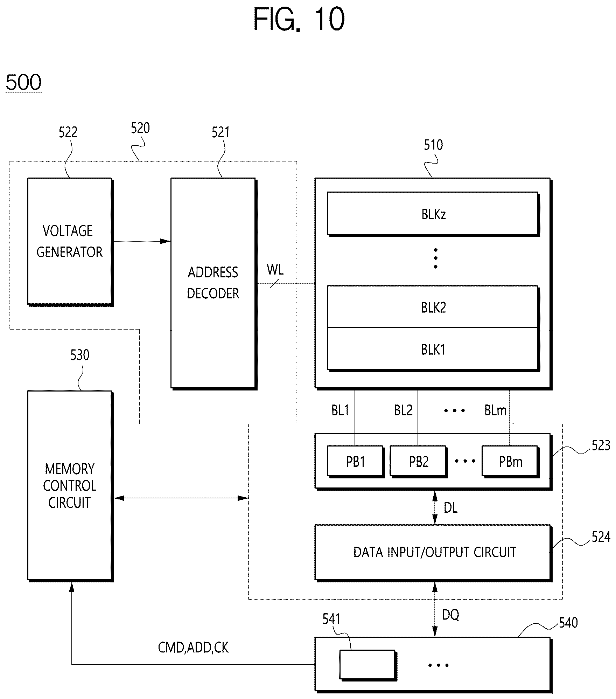

FIG. 10 is a diagram illustrating a configuration of a semiconductor memory apparatus 500, according to an embodiment of the present disclosure.

Referring to FIG. 10, the semiconductor memory apparatus 500 may include a memory cell array 510, a peripheral circuit 520, a memory control circuit 530, and an input/output pad array 540.

The peripheral circuit 520 may include an address decoder 521, a voltage generator 522, a read/write circuit 523, and a data input/output circuit 524.

The input/output pad array 540 may include a plurality of pads 541 to receive a command CMD, an address ADD, and a clock signal CK and to transmit and receive data DQ and a data strobe signal.

The memory cell array 510 may be coupled to the address decoder 521 through wordlines WL, and to the read/write circuit 523 through bitlines BL1 to BLm. The memory cell array 510 may include a plurality of memory blocks BLK1 to BLKz. The plurality of memory blocks BLK1 to BLKz may be coupled to the address decoder 521 through the wordlines WL and to the read/write circuit 523 through the bitlines BL1 to BLm. Each of the plurality of memory blocks BLK1 to BLKz includes a plurality of memory cells. The memory cells may be nonvolatile memory cells. Each memory block in the memory cell array 510 may include a plurality of pages. Among the memory cells, those coupled to the same wordline may be defined as one page. The plurality of memory blocks BLK1 to BLKz may store normal data, i.e., data that is transmitted and received through a normal read operation and a normal write operation.

Each of the memory cells of the memory cell array 510 may be configured as a single-level cell (SLC) storing one data bit, a multi-level cell (MLC) storing two data bits, a triple-level cell (TLC) storing three data bits, or a quad-level cell (QLC) storing four data bits.

The peripheral circuit 520 may drive the memory cell array 510 to perform a program operation, a read operation, and an erase operation.

The address decoder 521 may be coupled to the memory cell array 510 through the wordlines WL. The address decoder 521 may be configured to operate in response to control by the memory control circuit 530. The address decoder 521 may receive the address ADD from the memory control circuit 530.

The address decoder 521 may decode a block address from the address ADD. The address decoder 521 may select at least one memory block from among the memory blocks BLK1 to BLKz based on the decoded block address. The address decoder 521 may decode a row address from the received address ADD. Based on the decoded row address, the address decoder 521 may apply voltages provided from the voltage generator 522 to at least one wordline WL to select at least one wordline in the selected memory block.

The address decoder 521 may perform a program operation by applying a program voltage to the selected wordline and a pass voltage lower than the program voltage to unselected wordlines.

The address decoder 521 may perform a read operation by applying a read voltage to the selected wordline and a pass voltage higher than the read voltage to the unselected wordlines.

An erase operation in the semiconductor memory apparatus 500 may be performed on a memory block basis. The address decoder 521 may decode the block address and select one memory block based on the decoded block address. The address decoder 521 may apply a ground voltage to wordlines of the selected memory block and apply an erase voltage to a bulk region in which the selected memory block is formed to perform the erase operation.

The voltage generator 522 may generate various voltages used for operation of the semiconductor memory apparatus 500, such as a read voltage, a pass voltage, a program voltage, and an erase voltage, under the control of the memory control circuit 530, and may provide the generated voltages to the address decoder 521.

The read/write circuit 523 may include a plurality of page buffers, e.g., page buffers PB1 to PBm. The page buffers PB1 to PBm may be coupled to the memory cell array 510 through first to m-th bitlines BL1 to BLm, respectively. The page buffers PB1 to PBm may operate in response to control signals received from the memory control circuit 530.

The page buffers PB1 to PBm may perform data communication with the data input/output circuit 524. The page buffers PB1 to PBm may perform a program operation by receiving data to be stored from the data input/output circuit 524 through data lines DL and transmitting the data to the memory cell array 510. The read/write circuit 523 may perform a read operation by reading data from memory cells of a selected page through the bitlines BL and outputting the read data to the data input/output circuit 524. The read/write circuit 523 may perform an erase operation by floating the bitlines BL.

The data input/output circuit 524 may be coupled between the page buffers PB1 to PBm and the input/output pad array 540. The data input/output circuit 524 may perform data input and output operations in response to control signals received from the memory control circuit 530. During a read operation, the data input/output circuit 524 may output data delivered from the memory blocks BLK1 to BLKz through the page buffers PB1 to PBm to an external system of the semiconductor memory apparatus 500 through the input/output pad array 540. The external system may be a memory controller, a host, or a test device.

During a write operation, the data input/output circuit 524 may deliver data input from the external system through the input/output pad array 540 to the page buffers PB1 to PBm.

The data input/output circuit 524 may include a receiving circuit. The receiving circuit may include a receiving block configured to amplify an input signal, and the receiving block may be configured to receive a first power supply voltage before a data input interval, to receive a second power supply voltage having a level higher than that of the first power supply voltage during the data input interval, and to receive the first power supply voltage after the data input interval ends. The receiving circuit of the data input/output circuit 524 may be configured similarly to the receiving circuit 100 or the receiving circuit 200, according to an embodiment of the present disclosure.

The memory control circuit 530 may be coupled to the address decoder 521, the voltage generator 522, the read/write circuit 523, the data input/output circuit 524, and the input/output pad array 540. The memory control circuit 530 may receive the command CMD, the address ADD, and the clock signal CK through the input/output pad array 540. The memory control circuit 530 may generate control signals for controlling overall operations of the semiconductor memory apparatus 500, including data input and data output. The control signals output from the memory control circuit 530 may include the data input flag D-IN, the active signal ACT-CHP, the double data rate mode signal DDR, and the differential mode signal DIFF.

The semiconductor memory apparatus 500 may be configured to operate in one of the double data rate mode and the single data rate mode, and may store the double data rate mode signal DDR at different logic levels depending on the set mode.

The semiconductor memory apparatus 500 may also be configured to operate in one of the differential mode and the single-ended mode as a signal processing scheme, and may store the differential mode signal DIFF at different logic levels depending on the set mode.

Concepts are disclosed in conjunction with examples and embodiments. Those skilled in the art will understand that various modifications, additions, combinations, and/or substitutions are possible without departing from the scope and technical concepts of the present disclosure. The embodiments disclosed in the present specification should be considered from an illustrative standpoint and not a restrictive standpoint. Therefore, the scope of the present disclosure is not limited to the provided descriptions. All changes within the meaning and range of equivalency of the claims are included within their scope.

## Claims

1. A receiving circuit, comprising:
a first receiving block configured to receive a second power supply voltage and configured to perform first signal processing on an input signal using the second power supply voltage to generate a preliminary output signal;
a second receiving block configured to receive a first power supply voltage and configured to perform second signal processing on the preliminary output signal using the first power supply voltage to generate an output signal;
a first rectifying circuit configured to generate the first power supply voltage; and
a second rectifying circuit configured to generate the second power supply voltage having a voltage level higher than a voltage level of the first power supply voltage.

2. A receiving circuit, comprising:
a first receiving block configured to receive a third power supply voltage and configured to generate a preliminary output signal by performing a first signal processing operation on an input signal using the third power supply voltage;
a second receiving block configured to receive a first power supply voltage and configured to generate an output signal by performing a second signal processing operation on the preliminary output signal using the first power supply voltage;
a first rectifying circuit configured to generate the first power supply voltage;
a second rectifying circuit configured to generate a second power supply voltage having a voltage level higher than a voltage level of the first power supply voltage; and
a multiplexing circuit configured to output the second power supply voltage as the third power supply voltage when a voltage selection signal is at a first logic level, and configured to output the first power supply voltage as the third power supply voltage when the voltage selection signal is at a second logic level.

3. The receiving circuit of at least one of claim 1 and claim2, wherein the first receiving block includes at least one amplification circuit configured to operate in a current mode logic scheme, and the amplification circuit is configured to amplify the input signal according to a reference voltage and to output a differential signal.

4. The receiving circuit of claim 3, wherein the second receiving block includes a differential/single signal conversion circuit configured to convert the differential signal into a single-ended signal.

5. The receiving circuit of claim 2, further comprising a receiving control circuit configured to set the voltage selection signal to the first logic level during an interval in which a data input operation is performed according to a control signal.

6. The receiving circuit of claim 5, wherein the receiving control circuit is configured to receive, as the control signal, a chip enable signal and a data input flag indicating a data input state, and configured to generate the voltage selection signal according to the chip enable signal and the data input flag.

7. The receiving circuit of claim 2, further comprising a receiving control circuit configured to set the voltage selection signal to the first logic level during an interval in which a data input operation is performed and during an interval set to a low-speed standby mode according to a control signal.

8. The receiving circuit of claim 7, wherein the receiving control circuit is configured to receive, as the control signal, an active signal, a chip enable signal, and a data input flag indicating a data input state, and configured to generate the voltage selection signal according to the active signal, the chip enable signal, and the data input flag.

9. The receiving circuit of claim 2, further comprising a receiving control circuit configured to set the voltage selection signal to the first logic level when a first operation condition or a second operation condition is satisfied according to a control signal.

10. The receiving circuit of claim 9, wherein the receiving control circuit is configured to receive, as the control signal, an active signal, a chip enable signal, a double data rate mode signal, a differential mode signal, and a data input flag indicating a data input state, and configured to generate the voltage selection signal according to the active signal, the chip enable signal, the double data rate mode signal, the differential mode signal, and the data input flag.

11. The receiving circuit of at least one of claim 1 and claim2, wherein the first receiving block and the second receiving block are configured to commonly receive a receiving enable signal and to be activated according to the receiving enable signal.

12. The receiving circuit of claim 14, further comprising a delay circuit configured to generate the receiving enable signal by delaying the voltage selection signal by a predetermined delay time interval.

13. A semiconductor memory apparatus, comprising:
a memory cell array;
an input/output pad array configured to receive a command, an address, and a clock signal, the input/output pad array including a plurality of pads for inputting and outputting data; and
a data input/output circuit coupled between the memory cell array and the input/output pad array and including a receiving circuit,
wherein the receiving circuit is configured to supply a first power supply voltage before a data input interval, configured to supply a second power supply voltage having a voltage level higher than a voltage level of the first power supply voltage during the data input interval, and configured to supply the first power supply voltage after the data input interval ends.

14. The semiconductor memory apparatus of claim 13, wherein the receiving circuit comprises:
a first receiving block configured to receive a third power supply voltage and configured to amplify an input signal using the third power supply voltage and to generate a differential signal;
a second receiving block configured to receive the first power supply voltage and configured to convert the differential signal into a single-ended signal using the first power supply voltage and configured to generate an output signal; and
a multiplexing circuit configured to output the second power supply voltage as the third power supply voltage when a voltage selection signal is at a first logic level and configured to output the first power supply voltage as the third power supply voltage when the voltage selection signal is at a second logic level.

15. The semiconductor memory apparatus of claim 14, further comprising a receiving control circuit configured to receive a chip enable signal and a data input flag indicating a data input state and configured to generate the voltage selection signal according to the chip enable signal and the data input flag.

16. The semiconductor memory apparatus of claim 14, further comprising a receiving control circuit configured to receive an active signal, a chip enable signal, and a data input flag indicating a data input state and configured to generate the voltage selection signal according to the active signal, the chip enable signal, and the data input flag.

17. The semiconductor memory apparatus of claim 14, further comprising a receiving control circuit configured to receive an active signal, a chip enable signal, a double data rate mode signal, a differential mode signal, and a data input flag indicating a data input state and configured to generate the voltage selection signal according to the active signal, the chip enable signal, the double data rate mode signal, the differential mode signal, and the data input flag.

18. The semiconductor memory apparatus of claim 14, wherein the first receiving block and the second receiving block are configured to commonly receive a receiving enable signal and to be activated according to the receiving enable signal.

19. The semiconductor memory apparatus of claim 18, further comprising a delay circuit configured to generate the receiving enable signal by delaying the voltage selection signal by a predetermined delay time interval.
